# EUROPÄISCHE PATENTANMELDUNG

(11) **EP 4 249 626 A1**
(43) Veröffentlichungstag der Anmeldung: **27.09.2023**
(21) Anmeldenummer: 22179073.6
(22) Anmeldetag: 15.06.2022
(51) Int. Cl.: C23C 8/02, C23C 8/10, C23C 8/12, C23C 8/14, C23C 8/36, C23C 8/38, C23C 8/80, H01J 37/00

(54) **VERFAHREN UND VORRICHTUNG ZUM PLASMANITRIEREN UND ANSCHLIESSENDEM OXIDIEREN EINER OBERFLÄCHE EINES BAUTEILS**

(30) Priorität: 22.03.2022 DE 102022106661
(71) Anmelder: Plasmanitriertechnik Dr. Böhm GmbH, 09116 Chemnitz (DE)
(72) Erfinder: Böhm, Andreas, 09228 Wittgensdorf (DE)
(74) Vertreter: Rumrich, Gabriele

(57) **Zusammenfassung**

Die Erfindung betrifft ein Verfahren und eine Vorrichtung zum Plasmanitrieren einer Oberfläche eines Bauteils und anschließendem Oxidieren in einer Vorrichtung, aufweisend eine Vakuumretorte (1) mit einem, im Inneren der Vakuumretorte (1) angeordneten Aktivgitter (2) und einem Gaseinlass (4) zum Einleiten eines Prozessgases und einem Gasauslass (5) zum Abführen des Prozessgases, eine Plasmaquelle (6) zum Beglimmen des Aktivgitters (2) und eine Biasquelle (7) zum Anlegen einer Biasspannung an einem Bauteilträger (9), wobei der Wärmeeintrag in die Vakuumretorte (1) mittels einer, außerhalb der Vakuumretorte (1) angeordneten Wandheizung (3) und einer elektrischen Leistung der Plasma- und Biasquelle (6, 7) geregelt wird, wobei die Wandheizung (3), die Plasmaquelle (6) und die Biasquelle (7) während des Plasmanitrierens unabhängig voneinander geregelt sind, wobei die Bauteiloberfläche nach dem Plasmanitrieren oxidiert wird, indem ein Sauerstoffträger in die Vakuumretorte (1) gegeben wird und die Oxidation nach dem Plasmanitrieren bei geringen Prozessdrücken (ca. <50Pa) mit aktivem Plasma am Aktivgitter (2) und bei höheren Prozessdrücken (ca. >500Pa) ohne aktivem Plasma am Aktivgitter innerhalb des gleichen Prozesses erfolgt und die Bauteiltemperatur während des Oxidationsprozesses konstant gehalten wird wobei die konstante Bauteiltemperatur zwischen 500°C bis 540°C eingestellt wird.

## Beschreibung

Die Erfindung betrifft ein Verfahren und eine Vorrichtung zum Plasmanitrieren und anschließendem Oxidieren einer Oberfläche eines Bauteils und findet insbesondere für die Behandlung von metallischen Oberflächen Anwendung.

Plasmanitrieren ist ein thermochemisches Wärmebehandlungsverfahren im Vakuum, welches die Oberflächenhärte und Verschleißfestigkeit metallischer Werkstoffe, wie vorzugsweise Stahl, aber auch Titan- und Aluminiumwerkstoffe, steigert sowie die Korrosionsbeständigkeit verbessert.

Plasma beschreibt den vierten Aggregatzustand, ein elektrisch leitfähiges Gas. Beim Plasmanitrieren dient dies zur Erwärmung des Behandlungsgutes, sowie als Treiber der thermochemischen Reaktionen bei der Wärmebehandlung, zu der es eingesetzt wird. Plasmanitrieren mit Zusatz eines Kohlenstoffträgergases wird formal als Plasmanitrocarburieren bezeichnet. In der Praxis und in der vorliegenden Erfindung wird das Verfahren unter dem Begriff Plasmanitrieren eingeschlossen. Die Behandlung und Flutung der Plasmanitrieranlage mit einem sauerstoffhaltigen Gasgemisch als anschließenden Teil der Plasmanitrierbehandlung nennt man Oxidieren. Dies dient der Steigerung der Korrosionsbeständigkeit und Erzeugung einer dunkelblauen bis schwarzen Bauteiloberfläche.

Durch die Kombination von Plasmanitrieren (bzw. Plasmanitrocarburieren) mit dem Oxidieren entsteht an der Bauteiloberfläche eine Oxidschicht, welche maßgeblich die Korrosionsbeständigkeit verbessert. Darunter liegt die Verbindungsschicht, ein reines Eisennitrid, welches sowohl Korrosionsschutz bietet, als auch durch seine Härte vor Bauteilverschleiß schützt. Unter dieser Schicht liegt die Diffusionszone, die maßgeblich die Oberflächenhärte und Verschleißbeständigkeit des Bauteils bestimmt.

Gemäß dem Stand der Technik lässt sich das Plasmanitrieren in drei Technologien aufteilen. Das konventionelle Plasmanitrieren in einem Kaltwand-Reaktor, das konventionelle Plasmanitrieren in einem Warmwand-Reaktor und das Plasmanitrieren mit einem Aktivgitter im Kaltwand-Reaktor.

Die Kaltwandanlage weist eine Wasserkühlung in der Ofenwand auf. Das Sputtern, aufheizen der Anlage und das Plasmanitrieren erfolgen durch Plasma am Werkstück. Die Plasmaoxidation wird mit Sauerstoffträgergas und aktivem Plasma am Werkstück bei geringen Prozessdrücken von <500 Pa (Pascal) realisiert, wobei die Temperaturregelung über Plasma am Werkstück erfolgt.

Der geringe Prozessdruck erlaubt eine anfängliche Ausbildung der Oxidschicht. Aufgrund des allgemein geringen Stickstoffangebotes wird die Oxidschicht jedoch nachteiliger Weise nicht dick und widerstandsfähig genug. Es bedarf höherer Prozessdrücke für eine gewisse Haltezeit bei Bauteiltemperaturen von 500°C und mehr, damit sich eine ausreichend dicke Oxidschicht bilden kann. Die Haltezeiten und Haltetemperaturen lassen sich mit einer Kaltwandanlage nicht realisieren, da die erforderlichen Prozessdrücke die Plasmazündung und damit das Halten der Oxidationstemperatur verhindern; Heiz- und Plasmaparameter lassen sich nur in geringem Maße getrennt voneinander einstellen.

Bei dem Plasmanitrieren mit Warmwand nach dem Stand der Technik kann mittels der Warmwand eine Temperaturführung erfolgen. Es erfolgt zuerst das Sputtern (Reinigen der Werkstückoberfläche mit Plasma). Danach wird in der gleichen Anlage das Plasmanitrieren durchgeführt, wobei das Plasma am Werkstück und an der Warmwand auftritt.

Das optionale anschließende Oxidieren erfolgt in einem gesonderten Prozess in einer separaten Anlage oder im gleichen Prozess in der gleichen Warmwandanlage nach dem Stand der Technik mehrstufig, wobei abwechselnd
a) ein Fluten mit Sauerstoffträgergas auf höhere Prozessdrücke (>500Pa bis Atmosphärendruck),
b) ein Evakuieren,
c) eine Plasmaoxidation mit Sauerstoffträgergas und aktivem Plasma am Werkstück bei geringen Prozessdrücken (ca. <500Pa)
   durchgeführt wird.

Bei allen Schritten a), b), c) erfolgt ein konstantes Halten der Behandlungstemperatur mit der Warmwand und dem Plasma am Werkstück (wenn aktiv). Die Reihenfolge und Häufigkeit der Schritte Schritt a) bis c) kann variieren.

Nachteilig ist, dass weniger Einflussgrößen und Freiheitsgrade existieren, um die Schichtbildung zu steuern. Der Charakter der Plasmabeglimmung im Prozess weist Geometrieeffekte auf. In Folge kann das Prozessergebnis stark in Abhängigkeit der Werkstückgeometrien variieren.

Beim Plasmanitrieren mit Aktivgitteranlage wird herkömmlicher Weise in die Ofenwand eine Wasserkühlung integriert. Die Erwärmung der Anlage erfolgt mittels eines Plasmas am Werkstück oder eines Plasmas am Aktivgitter und optionaler Biasspannung am Werkstück. Demzufolge wird das verfahrensmäßige Sputtern mit Plasma am Werkstück oder Plasma am Aktivgitter und optionaler Biasspannung am Werkstück und das verfahrensgemäße Aufheizen mittels des Plasmas am Aktivgitter und optionaler Biasspannung am Werkstück oder mittels Plasma am Werkstück durchgeführt. Das Plasmanitrieren erfolgt durch Plasma am Aktivgitter mit oder ohne Biasspannung am Werkstück. Die anschließende Plasmaoxidation mit Sauerstoffträgergas und aktivem Plasma am Werkstück erfolgt bei bevorzugt geringen Prozessdrücken (ca. <500 Pascal) und die Temperaturregelung über Plasma am Aktivgitter und Biasspannung am Werkstück oder

Plasma am Werkstück.

Der geringe Prozessdruck erlaubt eine anfängliche Ausbildung der Oxidschicht. Aufgrund des allgemein geringen Stickstoffangebotes wird die Oxidschicht jedoch auch hier nicht dick und widerstandsfähig genug. Es bedarf höherer Prozessdrücke für eine gewisse Haltezeit bei Bauteiltemperaturen von 500°C und mehr, damit sich eine ausreichend dicke Oxidschicht bilden kann. Die Haltezeiten und Haltetemperaturen lassen sich mit einer Kaltwandanlage nicht realisieren, da die erforderlichen Prozessdrücke die Plasmazündung und damit das Halten der Oxidationstemperatur verhindern. Heiz- und Plasmaparameter lassen sich nur in geringem Maße getrennt voneinander einstellen.

Aus der Druckschrift DE 10 2016 218 979 A1 ist eine Vorrichtung zur plasmagestützten Erzeugung von hochreaktiven Prozessgasen bekannt, wobei das Plasmanitrieren von Oberflächen beschrieben wird. Gemäß der Druckschrift weist die Vorrichtung ein Aktivgitter und eine in dem Reaktionsraum angeordnete regelbare Heizung auf, wobei die Heizung an der Innenwand des Reaktionsraums um das Aktivgitter herum oder an mindestens zwei gegenüberliegenden Seiten des Aktivgitters angeordnet ist. Alternativ ist die Heizung an der Arbeitsplatte angeordnet.

Das Aktivgitter weist eine Gitterdecke und eine sich nach unten erstreckende Gitterwand auf. Wie das Aktivgitter in dem Reaktionsraum befestigt ist, wird nicht offenbart.

Des Weiteren ist die mindestens eine Arbeitsplatte an einer zusätzlichen elektrischen Biasspannungsquelle angeschlossen, wobei die Biasspannungsquelle ein elektrisch negatives Spannungspotential in Bezug zur elektrischen Spannungsquelle aufweist.

Des Weiteren wird eine Zerstörung der Passivschicht durch eine in-situ Voroxidation beziehungsweise ein Oxinitrieren mit Prozessgasen, deren Oxidationsgrenze dicht oberhalb der Oxidationsgrenze des Eisens beschrieben. Dies dient jedoch lediglich der Vorbereitung der Bauteile für den Nitriervorgang.

In der Druckschrift EP 2 986 751 B1 wird ein Verfahren und eine Vorrichtung für das thermochemische Härten von Bauteilen beschrieben. In der beschriebenen Vorrichtung sind in dem Reaktionsraum eine Aktivgitterelektrode und ein Heizelement angeordnet, wobei das Heizelement nahe der Wand angeordnet ist.

Des Weiteren weist die Vorrichtung nur eine Spannungsquelle/Plasmaquelle auf. Gemäß dem beschriebenen Verfahren erfolgt das Aufkohlen bei 900°C bis 1050°C.

Das Plasmanitrieren mit Aktivgitter wird gemäß dem vorgenannten Stand der Technik ausschließlich in Kaltwand-Reaktoren durchgeführt. Dies hat den Nachteil, dass die Plasmaleistung des Aktivgitters direkt an den Wärmeeintrag zum Erreichen der gewünschten Prozesstemperatur gekoppelt ist und damit nur in engen Grenzen variiert werden kann. Da die elektrische Leistung am Behandlungsgut (Bias-Leistung) und Aktivgitter mit dem notwendigen Leistungseintrag zur Wärmeerzeugung gekoppelt ist, lassen sich die Plasmaparameter am Bauteil nicht unabhängig von der Aktivgitterleistung beziehungsweise dem Aktivgitterplasma einstellen. Damit fehlen prozesstechnisch relevante Freiheitsgrade für eine optimierte Nitrierschichterzeugung während des plasmagestützten Wärmebehandlungsprozesses.

Aus der Druckschrift EP 0 786 793 B1 geht bereits eine Vorrichtung und ein Verfahren zum Plasmanitrieren einer Oberfläche eines Bauteils hervor, wobei die Vorrichtung einen vakuumdichten Kessel, einen darin angeordneten Drahtgitterkäfig als Aktivgitter, eine Gaseinlassvorrichtung zu Einleiten von Reaktions- und/oder Inertgasen, eine Saugleitung als Gasauslass eine Plasmaquelle, eine Spannungsquelle (BZ 44) als Biasquelle zum Anlegen einer Spannung an die Werkstücke und eine Heizvorrichtung aufweist, wobei die Heizeinrichtung an der Außenseite der Behälterwand anliegt und durch die der Innenraum beheizt werden kann. Der Drahtgitterkäfig ist nach oben offen und weist eine senkrechte Wand und einen Boden auf, der sich unterhalb eines Werkstückaufnahmebereiches erstreckt.

Auch aus EP 3 842 565 ist eine Vorrichtung zum Plasmanitrieren zu entnehmen, wobei mehrere Heizelemente in einer Vakuumkammer angeordnet sind, die unabhängig voneinander gesteuert werden können und vertikale Heizzonen bilden, deren Temperatur unabhängig voneinander gesteuert werden kann. Ein Aktivgitter wird hier nicht verwendet.

Die Druckschrift WO 2017/122 044 A1 offenbart eine gattungsgemäße Vorrichtung, die neben Heizelementen auch Kühlvorrichtungen für jede der drei Behandlungszonen aufweist. Eine Luftkühlung wird jedoch nicht explizit genannt und es wird kein Aktivgitter verwendet.

Der gesamte Stand der Technik realisiert keinen Oxidationsprozess nach dem Plasmanitrieren mit Aktivgitter und Warmwand.

Aufgabe der Erfindung ist es, ein Verfahren und eine Vorrichtung zum Plasmanitrieren einer Oberfläche eines Bauteils mit anschließendem Oxidieren zu entwickeln, welche einen einfachen konstruktiven Aufbau aufweist und eine qualitativ hochwertige gleichmäßige Nitrierschichterzeugung sowie die Bildung einer Oxidschicht auf dem Bauteil ermöglicht.

Diese Aufgabe wird mit den Merkmalen des ersten und sechsten Patentanspruchs gelöst.

Vorteilhafte Ausgestaltungen ergeben sich aus den Unteransprüchen.

Die erfindungsgemäße Vorrichtung zum Plasmanitrieren einer Oberfläche eines Bauteils, weist eine Vakuumretorte mit einem, im Inneren der Vakuumretorte angeordneten Aktivgitter und einem Gaseinlass zum Einleiten eines Prozessgases und einem Gasauslass zum Abführen des Prozessgases auf. Zudem ist eine Plasmaquelle zum Beglimmen des Aktivgitters und eine Biasquelle zum Anlegen einer Biasspannung an einem Bauteilträger vorgesehen, wobei an der Außenwand der Vakuumretorte eine Wandheizung zum Beheizen der Vakuumretorte angeordnet ist.

Bevorzugt ist die Wandheizung aus mehreren, in Zonen unterteilt angeordneten Heizelementen gebildet, und weist eine getrennt regelbare Temperaturführung auf. Je nach Größe der Vorrichtung sind in einer vorteilhaften Ausgestaltung mindestens zwei bis sechs Heizzonen mit zugehörigen Heizelementen vorgesehen. So können bei kleinen Anlagen nur zwei Zonen existieren. Bei sehr hohen Anlagen können es auch mehrere Zonen vorgesehen sein, beispielsweise kann eine Plasmanitrieranlagen mit 6m Nutzhöhe sechs Heizzonen aufweisen.

Besonders bevorzugt ist eine Luftkühlung der Vakuumretorte vorgesehen. Mit der Luftkühlung sind mehrere Kühlzonen getrennt steuerbar. Besonders bevorzugt entspricht die Anzahl der Heizzonen der Anzahl der Kühlzonen. Zusätzlich werden Dichtelemente wie sie beispielsweise an Sichtfenstern oder Dichtflanschen zu finden sind mittels Wasser gekühlt.

So kann eine effektive Steuerung der Temperatur innerhalb der Vakuumretorte in den einzelnen Temperaturzonen erfolgen.

Derart ist ein unabhängiger Betrieb und Wahl der Prozessparameter an Plasmaquelle, Biasquelle und der Wandheizung zur Beeinflussung des Schichtaufbaus beim Plasmanitrieren und Oxidieren möglich.

In einer ersten Ausgestaltungsform ist das Aktivgitter in der Vakuumretorte stehend angeordnet.

Alternativ ist das Aktivgitter in der Vakuumretorte hängend angeordnet. Dabei weist das Aktivgitter oben eine Gitterdecke auf, die sich unterhalb des Deckenbereichs der Vakuumretorte und bevorzugt parallel zum Deckenbereich erstreckt. Weiterhin kann sich in einer Variante an die Gitterdecke eine Gitterwand anschließen, die sich entlang des Wandbereiches der Vakuumretorte erstreckt.

Bevorzugt ist der Gaseinlass im Bereich des Aktivgitters (insbesondere mittig) angeordnet, wobei das Prozessgas über das Aktivgitter führbar ist. An dem Aktivgitter wird das Prozessgas ionisiert und thermochemisch reaktiv.

Durch die elektrische Kontaktierung eines Bauteilträgers mit der Biasquelle werden die am Aktivgitter erzeugten, reaktiven Teilchen auf das Behandlungsgut geleitet bzw. davon angezogen.

Die Vorrichtung weist in einer bevorzugten Ausgestaltung Mittel für eine präzise Temperaturmessung in jeder Zone der Vakuumretorte auf.

Das erfindungsgemäße Verfahren zum Plasmanitrieren einer Oberfläche eines Bauteils, erfolgt in einer Vorrichtung, aufweisend eine Vakuumretorte mit einem, im Inneren der Vakuumretorte angeordneten Aktivgitter und einem Gaseinlass zum Einleiten eines Prozessgases und einem Gasauslass zum Abführen des Prozessgases, eine Plasmaquelle zum Beglimmen des Aktivgitters und eine Biasquelle zum Anlegen einer Biasspannung an dem Bauteilträger, wobei der Wärmeeintrag in die Vakuumretorte mittels einer, außerhalb der Vakuumretorte angeordneten Wandheizung und der elektrischen Leistung der Plasma- und Biasquelle geregelt wird, wobei die Wandheizung, die Plasmaquelle und die Biasquelle unabhängig voneinander geregelt sind und wobei die Bauteiloberfläche nach dem Plasmanitrieren oxidiert wird, indem ein Sauerstoffträger in die Vakuumretorte gegeben wird und
wobei das Behandeln mit Oxidation nach dem Plasmanitrieren
   ∘ bei geringen Prozessdrücken (ca. <500Pa) mit aktivem Plasma am Aktivgitter
   ∘ und bei höheren Prozessdrücken (ca. >500Pa) ohne aktivem Plasma am Aktivgitter
innerhalb des gleichen Prozesses erfolgt und wobei die Bauteiltemperatur während des Oxidationsprozesses konstant gehalten wird und die konstante Bauteiltemperatur zwischen 500°C bis 540°C eingestellt wird.

Gemäß dem Verfahren wird besonders bevorzugt bei Überschreitung einer Solltemperatur eine Luftkühlung aktiviert, die die Temperatur reduziert, indem mehr Wärmeenergie aus der Vakuumretorte und dem Behandlungsgut ausgetragen wird.

Mit der erfindungsgemäßen Lösung mittels das Plasmanitrieren mit Aktivgitter und Wandheizung bieten sich Vorteile und neue prozesstechnische Freiheitsgrade in Bezug auf den Stand der Technik.

Ein Vorteil der Erfindung besteht in der unabhängigen Erwärmung des Bauteils von den Parametern der Plasmaquelle und der Biasquelle. Die Wandheizung unterstützt den Wärmeeintrag und Haltevorgang der Solltemperatur ungeachtet der durch Plasma- und Biasquelle eingebrachten Plasmaleistung. Ist die Plasmaleistung so hoch, dass die Solltemperatur überschritten wird, regelt die zur Heizzone korrespondierende Luftkühlung die Temperatur nach unten, indem mehr Wärmeenergie ausgetragen wird. Dies ist bei konventionellen Aktivgitteranlagen mit Kaltwand gemäß dem Stand der Technik nicht möglich.

Des Weiteren gibt die Vorrichtung die Möglichkeit der variablen Regelung der Plasmaleistung am Gitter und der elektrischen Parameter (Bias) am Behandlungsgut. Durch die Plasmaleistungsvariation am Aktivgitter kann die Erzeugungsrate reaktiver Gase unabhängig der Chargentemperatur direkt beeinflusst werden. Dies kann insbesondere für das Plasmanitrocarburieren zu einer verbesserten Prozessführung im Hinblick auf die Reduzierung der Rußbildung, welche infolge einer erhöhten Dissoziationsrate der genutzten kohlenstoffhaltigen Prozessgase auftritt, vorteilhaft genutzt werden. Die Variation der elektrischen Parameter am Behandlungsgut gestattet die direkte Beeinflussung der Stickstoff- beziehungsweise Kohlenstoffaufnahme in den Werkstoff. Durch eine von der Gitterleistung unabhängige Variation der Plasmaparameter direkt am Bauteil können somit neue Stickstoff- und Kohlenstoffverteilungen innerhalb der nitrierten Randschicht erzeugt und neue Materialeigenschaften generiert werden. Die Vorrichtung vereint den Vorteil der Prozesstemperaturerzeugung mittels einer unterstützenden Wandheizung sowie die Möglichkeit zur Nitrierung kleinster Bohrungen durch die Erzeugung reaktiver Gase am Aktivgitter.

Ein weiterer Vorteil ist die Durchführung von Behandlungen mit Oxidation nach dem Plasmanitrieren mit Aktivgitter innerhalb des gleichen Prozesses und der gleichen Vorrichtung. Die Oxidation dient der Steigerung des Korrosionsschutzes nach dem Plasmanitrieren.

Die Bauteiloberfläche wird nach dem Plasmanitrieren oxidiert, indem ein Sauerstoffträgergas (Wasserdampf H₂O, Sauerstoff O₂, Distickstoffmonoxid N₂O, Kohlenstoffdioxid CO₂, etc.) in die Vakuumretorte gegeben wird. Um eine stabile Oxidschicht zu erzeugen muss dabei die Chargentemperatur für eine gewisse Zeit konstant gehalten werden.

Verfahrensgemäß erfolgt zuerst das Sputtern und somit das Reinigen des/der Bauteile mittels Plasma am Werkstück oder Plasma am Aktivgitter und optionaler Biasspannung am Werkstück. Optional kann auch eine Temperaturführung mittels Warmwand erfolgen. Das Sputtern erfolgt dabei insbesondere unterhalb der Haltetemperatur. In der Regel erstreckt sich das Sputtern über den Temperaturbereich von Raumtemperatur bis ca. 300°C bei Drücken bevorzugt zwischen 10Pa bis 300Pa.

Das weitere Aufheizen der Anlage erfolgt bis zu einer Temperatur von ca. 300°C bis in den Bereich zwischen bevorzugt 450 °C und 600°C bei einem Druck insbesondere zwischen 100Pa bis 500Pa mittels des Plasmas am Werkstück oder am Aktivgitter sowie optionaler Biasspannung am Werkstück und optional mit der Warmwand. Nach dem Erreichen der für das Plasmanitrieren erforderlichen Temperatur erfolgt bei konstanter Temperatur das Plasmanitrieren durch Plasma am Aktivgitter mit oder ohne Biasspannung am Werkstück und Warmwand, durch welche die Temperatur konstant gehalten wird.

Die Temperatur beim Plasmanitrieren liegt dabei bevorzugt zwischen 450°C und 600°C bei einem Druck zwischen insbesondere 100Pa bis 500Pa.

Es wird dann das Oxidieren mehrstufig mit den nachfolgenden Schritten durchgeführt, wobei sich die Schritte abwechseln können:
a) Fluten mit Sauerstoffträgergas auf höhere Prozessdrücke (>500Pa bis Atmosphärendruck).
b) Evakuieren,
c) Plasmaoxidation mit Sauerstoffträgergas und aktivem Plasma am Werkstück bei geringen Prozessdrücken (ca. <500Pa),
d) Plasmaoxidation mit Sauerstoffträgergas und aktivem Plasma am Aktivgitter mit oder ohne aktiver Biasspannung bei geringen Prozessdrücken (ca. <500Pa),

Bei allen Schritten a) bis d) wird ein konstantes Halten der Behandlungstemperatur (bevorzugt 500°C bis 540°C) mit Warmwand, Plasma (wenn aktiv) und Bias (wenn aktiv) realisiert. Die Reihenfolge und Häufigkeit von Schritt a) bis d) kann variieren.

Durch die im Vergleich zum Stand der Technik zusätzliche Plasmaoxidation mit Sauerstoffträgergas und aktivem Plasma am Aktivgitter mit oder ohne aktiver Biasspannung bei geringen Prozessdrücken (ca. <500Pa) wird im Vergleich zum Stand der Technik Wärmeeintrag und Plasmaparameter unabhängig voneinander geregelt. Weiterhin existieren in der beschriebenen Konstellation keine geometrieabhängigen Plasmaeffekte am Werkstück. Die Bauteiloberfläche wird daher gleichmäßiger behandelt und die resultierenden Schichteigenschaften sind homogener über das gesamte Werkstück.

Der Prozessschritt Kühlen wird wie herkömmlich üblich durch Fluten der Behandlungskammer auf Drücke zwischen >500Pa bis Atmosphärendruck mit Sauerstoffträgergas oder Stickstoff realisiert.

Das Halten der Temperatur während des Oxidationsprozesses ist nur mit einer Warmwand beziehungsweise einer Wandheizung möglich, da die zur Oxidation notwendige Menge des Sauerstoffträgers den Prozessdruck soweit ansteigen lässt, dass das Zünden eines Plasmas und Wärmeeintrag über Plasma damit nicht mehr möglich ist. Das Plasma am Aktivgitter steht bei einzelnen Schritten der Oxidation, bei denen die Vakuumretorte insbesondere über einen Druck von 500Pa geflutet wird, nicht zur Verfügung, um die Temperatur der Charge zu halten.

Die angegebenen Drücke und Temperaturen können bevorzugt bis zu +/-10% variieren.

Die Erfindung wird nachfolgend an einem Ausführungsbeispiel und zugehörigen Zeichnungen näher erläutert.

Es zeigen:
- Figur 1: eine erfindungsgemäße Vorrichtung mit einem, in der Vakuumretorte stehenden isoliertem Aktivgitter,
- Figur 2: eine Vorrichtung mit einem hängend angeordneten Aktivgitter in der Vakuumretorte,
- Figur 3: eine alternative Ausgestaltung der Vorrichtung nach Figur 2.

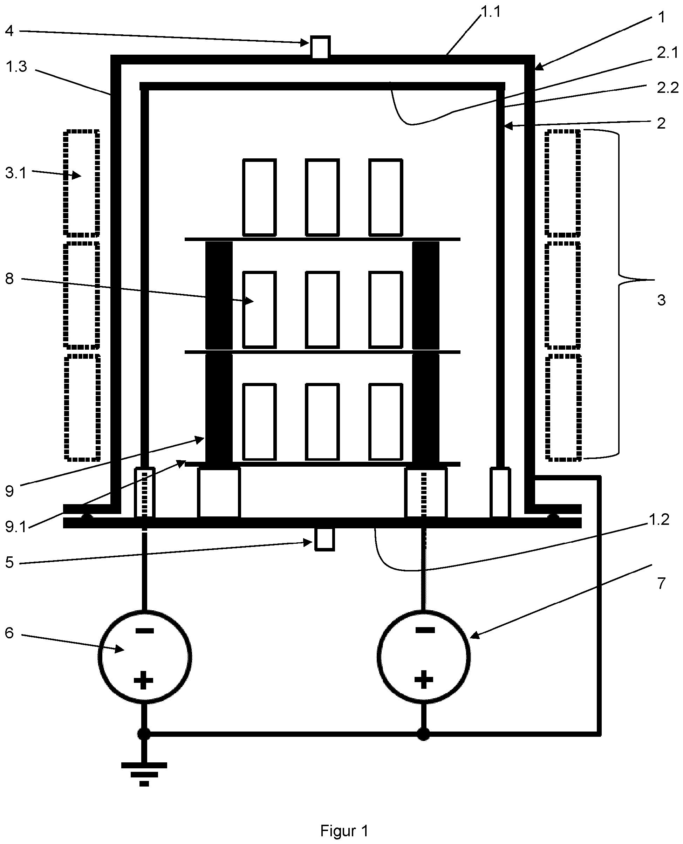

Eine erfindungsgemäße Vorrichtung mit einer Vakuumretorte 1 und einem darin angeordneten Aktivgitter 2 ist in der Figur 1 dargestellt. Das Aktivgitter 2 ist isoliert in der Vakuumretorte 1 stehend angeordnet. Es weist eine Gitterdecke 2.1 und eine sich nach unten erstreckende Gitterwand 2.2 auf.

Um die Vakuumretorte 1 ist eine Wandheizung 3 vorgesehen, die mehrere Heizelemente 3.1 aufweist. Die Heizelemente 3.1 erstrecken sich entlang des Außenumfangs der Vakuumretorte 1. Die Heizelemente 3.1 sind parallel zu der Außenwand der Vakuumretorte 1 außer von dieser am Umfang angeordnet. Auch eine Wasser- und/oder Luftkühlung kann in den Heizelementen 3.1 vorgesehen sein, um die Vakuumretorte 1 auf einer geforderten Solltemperatur zu halten.

Des Weiteren weist die Vorrichtung im Deckenbereich 1.1 der Vakuumretorte 1 einen Gaseinlass 4 zum Einleiten eines Prozessgases und am Bodenbereich 1.2 einen Gasauslass 5 zum Abführen des Prozessgases sowie eine Plasmaquelle 6 zum Beglimmen des Aktivgitters 2 und eine Biasquelle 7 zum Anlegen einer Biasspannung an der Oberfläche eines Bauteils 8 auf. Die Bauteile 8 sind auf einem Bauteilträger 9 angeordnet, die Gitterwand 2.2 umschließt die auf dem Bauteilträger 9 angeordneten Bauteile 8 und sitzt mit Ihrer Unterseite auf dem Bodenbereich 1.2 der Vakuumretorte 1 oder auf einer Plattform 9.1 des Bauteilträgers 9 (nicht dargestellt) auf.

Während des Prozesses wird das am Gaseinlass 4 einströmende Prozessgas über das Aktivgitter 2 geführt, wobei das Prozessgas an dem Aktivgitter 2 ionisiert und thermochemisch reaktiv wird. Durch die elektrische Kontaktierung des Bauteilträgers 9 und der Bauteile 8 mit der Biasquelle 7 werden die am Aktivgitter 2 erzeugten, reaktiven Teilchen auf das Bauteil 8 geleitet beziehungsweise davon angezogen.

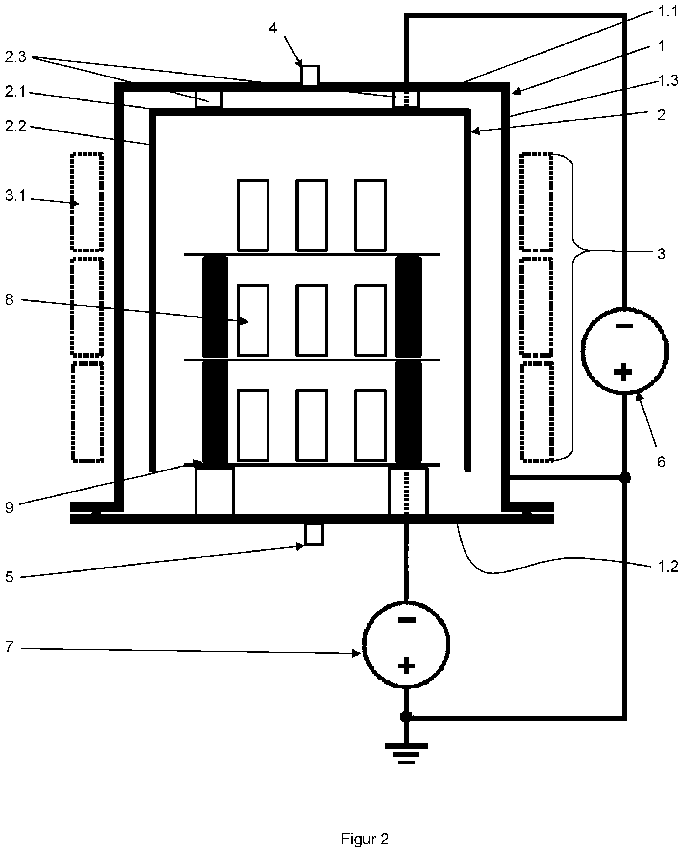

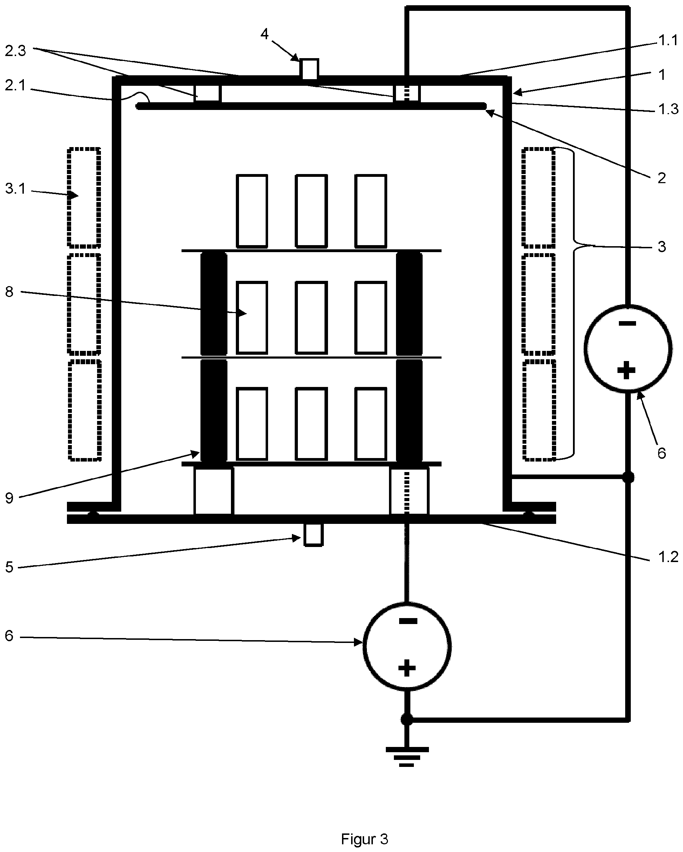

Eine alternative Ausgestaltung der erfindungsgemäßen Vorrichtung ist in den Figuren 2 und 3 dargestellt. Das Aktivgitter 2 ist gemäß Figur 2 und 3 hängend in der Vakuumretorte 1 angeordnet.

Gemäß der Vorrichtung nach Figur 2 erstreckt sich das Aktivgitter 2 mit seiner oben liegenden Gitterdecke 2.1 unterhalb des Deckenbereiches 1.1 der Vakuumretorte und ist mit seiner Gitterdecke 2.1 am Deckenbereich 1.1 über Befestigungselemente 2.3 hängend aufgenommen. Die Gitterdecke 2.1 ist dabei bevorzugt parallel zum Deckenbereich 1.1 der Vakuumretorte 1 ausgerichtet. Von der Gitterdecke 2.1 erstreckt sich die Gitterwand 2.2 bis zur Unterseite des Bauteilträgers 9 parallel zur Seitenwand 1.3 der Vakuumretorte 1.

Alternativ oder zusätzlich kann das Aktivgitter 2 auch mit seiner Gitterwand 2.2 an der Seitenwand 1.3 der Vakuumretorte 1 befestigt sein (nicht dargestellt).

Entgegen Figur 2 weist das Aktivgitter 2 gemäß Figur 3 nur eine Gitterdecke 2.1 auf, die ebenfalls hängend am Deckenbereich 1.1 der Vakuumretorte 1 angeordnet ist und sich ebenfalls bevorzugt parallel zum Deckenbereich 1.1 der Vakuumretorte 1 erstreckt.

Auf eine Gitterwand wurde hier verzichtet.

Auch bei dieser Variante ist eine alternative oder zusätzliche Befestigung der Gitterdecke 2.1 an der Seitenwand 1.3 der Vakuumretorte 1 möglich.

Durch die hängende Anordnung des Aktivgitters 2, dessen Gitterdecke 2.1 sich unterhalb des Deckenbereiches 1.1 erstreckt, strömt bei den Varianten nach den Figuren 2 und 3 das über den Gaseinlass 4 zugeführte Prozessgas über die Gitterdecke 2.1 des Aktivgitters 2, wodurch eine bessere Verteilung des für das Plasmanitrieren erforderlichen Prozessgases realisiert wird.

Weiterhin strömt auch das für die nachfolgende Oxidation der Bauteile 8 erforderliche Sauerstoffträgergas über die Gitterdecke 2.1 des Aktivgitters 2, wodurch ebenfalls eine gleichmäßigere Verteilung des Sauerstoffträgergases realisiert wird.

Dafür befindet sich der Gaseinlas 4 bevorzugt mittig im Deckenbereich 1.1.

Weiterhin wird bei den Varianten nach den Figuren 2 und 3 gleichzeitig mit dem Anheben des oberen Bereiches (Deckenbereich 1.1 mit Seitenwand 1.3) der Vakuumretorte 1 auch das Aktivgitter 2 angehoben und die behandelten Bauteile 8 können separat oder gemeinsam mit dem Bauteilträger 9 entnommen werden.

Die Funktionsweise und Regelung der Vorrichtung entspricht der Ausgestaltung gemäß der Figur 1.

Durch die Ergänzung der Aktivgitter-Plasmanitriertechnologie mit einer Warmwandheizung werden die für die Kaltwandtechnologie genannten Hindernisse überwunden und neue Potentiale in Bezug auf die erreichbare Verschleiß- und Korrosionsbeständigkeit erschlossen. Durch das Plasmanitrieren mit Aktivgitter werden Nitrierschichten hinsichtlich ihres strukturellen Aufbaus in hoher Variationsbreite erzeugt. Insbesondere der strukturelle Aufbau der Verbindungsschicht, welcher maßgeblich die Korrosionsbeständigkeit bestimmt, kann infolge der neuen Prozessfreiheitsgrade in weiten Grenzen variiert werden.

Die Warmwand in Form der Wandheizung sorgt für die Entkopplung der Prozesswärme von den Plasmaparametern sowie für eine effiziente Temperaturregelung und erlaubt das Nachoxidieren mit der notwendigen Haltezeit bei einer gleichmäßigen Prozesstemperatur.

Erstmalig erfolgt dabei eine Plasmaoxidation mit Sauerstoffträgergas und aktivem Plasma am Aktivgitter mit oder ohne aktiver Biasspannung bei geringen Prozessdrücken (ca. <500Pa).

Das Resultat ist eine Prozess- und Anlagentechnologie, mit welcher Randschichten erzeugbar sind, welche im Salzsprühnebeltest viele Stunden bestehen und den aktuellen Stand der Technik (Standzeiten von >500h im Salzsprühnebeltest) damit weit übertreffen.

### Bezugszeichenliste

- 1: Vakuumretorte
- 1.1: Deckenbereich
- 1.2: Bodenbereich
- 1.3: Wandbereich
- 2: Aktivgitter
- 2.1: Gitterdecke
- 2.2: Gitterwand
- 2.3: Befestigungselemente
- 3: Wandheizung
- 3.1: Heizelement
- 4: Gaseinlass
- 5: Gasauslass
- 6: Plasmaquelle
- 7: Biasquelle
- 8: Bauteil
- 9: Bauteilträger
- 9.1: Plattform

## Patentansprüche

1. Verfahren zum Plasmanitrieren einer Oberfläche eines Bauteils und anschließendem Oxidieren in einer Vorrichtung, aufweisend eine Vakuumretorte (1) mit einem, im Inneren der Vakuumretorte (1) angeordneten Aktivgitter (2) und einem Gaseinlass (4) zum Einleiten eines Prozessgases und einem Gasauslass (5) zum Abführen des Prozessgases, eine Plasmaquelle (6) zum Beglimmen des Aktivgitters (2) und eine Biasquelle (7) zum Anlegen einer Biasspannung an einem Bauteilträger (9), **dadurch gekennzeichnet,**
- **dass** der Wärmeeintrag in die Vakuumretorte (1) mittels einer, außerhalb der Vakuumretorte (1) angeordneten Wandheizung (3) und einer elektrischen Leistung der Plasma- und Biasquelle (6, 7) geregelt wird, wobei die Wandheizung (3), die Plasmaquelle (6) und die Biasquelle (7) während des Plasmanitrierens unabhängig voneinander geregelt sind,
- wobei die Bauteiloberfläche nach dem Plasmanitrieren oxidiert wird, indem ein Sauerstoffträger in die Vakuumretorte (1) gegeben wird
- und die Oxidation nach dem Plasmanitrieren
∘ bei geringen Prozessdrücken (ca. <50Pa) mit aktivem Plasma am Aktivgitter (2)
∘ und bei höheren Prozessdrücken (ca. >500Pa) ohne aktivem Plasma am Aktivgitter
innerhalb des gleichen Prozesses erfolgt und die Bauteiltemperatur während des Oxidationsprozesses konstant gehalten wird wobei die konstante Bauteiltemperatur zwischen 500°C bis 540°C eingestellt wird.

2. Verfahren nach Anspruch 1, **dadurch gekennzeichnet, dass** das Oxidieren mehrstufig mit den nachfolgenden Schritten durchgeführt, wobei sich die Schritte abwechseln können:
a) Fluten mit Sauerstoffträgergas auf höhere Prozessdrücke (>500Pa bis Atmosphärendruck).
b) Evakuieren,
c.) Plasmaoxidation mit Sauerstoffträgergas und aktivem Plasma am Werkstück bei geringen Prozessdrücken (ca. <500Pa),
d) Plasmaoxidation mit Sauerstoffträgergas und mit aktivem Plasma am Aktivgitter bei geringen Prozessdrücken (ca. <500Pa) mit oder ohne aktiver Biasspannung oder Plasmaoxidation mit Sauerstoffträgergas ohne aktivem Plasma am Aktivgitter bei höheren Prozessdrücken (ca. >500Pa) mit oder ohne aktiver Biasspannung wobei bei allen Schritten a) bis d) ein konstantes Halten der Behandlungstemperatur von insbesondere 500°C bis 540°C realisiert wird.

3. Verfahren nach Anspruch 1 oder 2, **dadurch gekennzeichnet, dass** bei Überschreitung einer Solltemperatur eine Luftkühlung und/oder eine Wasserkühlung die Temperatur reduziert, indem mehr Wärmeenergie ausgetragen wird.

4. Verfahren nach einem der Ansprüche 1 bis 3, **dadurch gekennzeichnet, dass** über den Gaseinlass (4) zum Plasmanitrieren das Prozessgas (bevorzugt Gasgemisch aus Stickstoff, Wasserstoff und einem kohlenstoffspendenden Gas (optional)zugeführt wird, dann die Vakuumkammer (1) evakuiert wird und danach für die Plasmaoxidation das Sauerstoffträgergas bevorzugt über den gleichen Gaseinlass (4) der Vakuumkammer (1) zugeführt und der Druck bei inaktivem Plasma am Aktivgitter von <500Pa auf höhere Gasdrücke bis hin zu Atmosphärendruck von 1013,2hPa erhöht wird.

5. Verfahren nach Anspruch 1 oder 2, **dadurch gekennzeichnet, dass** die aus mehreren in Zonen unterteilt angeordneten Heizelementen (3.1) bestehende Wandheizung (3) eine getrennt regelbare Temperaturführung mit mehreren einzelnen Temperaturzonen in Form mit Heizelementen (3.1) und Kühlzonen aufweist und dass bei Luftkühlung mehrere Kühlzonen getrennt steuerbar sind, wodurch eine Steuerung der Temperatur innerhalb der Vakuumretorte (1) in den einzelnen Temperaturzonen erfolgt.

6. Vorrichtung zum Plasmanitrieren und anschließendem Oxidieren einer Oberfläche eines Bauteils, aufweisend eine Vakuumretorte (1) mit einem, im Inneren der Vakuumretorte (1) angeordneten Aktivgitter (2) und einem Gaseinlass (4) zum Einleiten eines Prozessgases und einem Gasauslass (5) zum Abführen des Prozessgases, eine Plasmaquelle (6) zum Beglimmen des Aktivgitters (2) und eine Biasquelle (7) zum Anlegen einer Biasspannung an einem Bauteilträger (9), **dadurch gekennzeichnet, dass** an einer Außenwand der Vakuumretorte (1) eine Wandheizung (3) zum Beheizen der Vakuumretorte (1) angeordnet ist und dass die Vorrichtung zur Steuerung der Temperatur innerhalb der Vakuumretorte (1) mehrere in Heizzonen unterteilt angeordnete Heizelemente (3.1) mit getrennt regelbarer Temperaturführung und mehrere getrennt voneinander steuerbare Kühlzonen aufweist.

7. Vorrichtung zum Plasmanitrieren und anschließendem Oxidieren einer Oberfläche eines Bauteils zur Durchführung des Verfahrens nach Anspruch 1, aufweisend eine Vakuumretorte (1) mit einem, im Inneren der Vakuumretorte (1) angeordneten Aktivgitter (2) und einem Gaseinlass (4) zum Einleiten eines Prozessgases und einem Gasauslass (5) zum Abführen des Prozessgases, eine Plasmaquelle (6) zum Beglimmen des Aktivgitters (2) und eine Biasquelle (7) zum Anlegen einer Biasspannung an einem Bauteilträger (9), **dadurch gekennzeichnet, dass** das Aktivgitter (2) eine oben liegenden Gitterdecke (2.1) aufweist, die sich unterhalb des Deckenbereiches 1.1 der Vakuumretorte erstreckt, wobei das Aktivgitter (2) an einem Deckenbereich (1.1) und/oder einer Seitenwand (3.1) der Vakuumretorte (1) hängend aufgenommen ist.

8. Vorrichtung nach Anspruch 7, **dadurch gekennzeichnet, dass** sich von der Gitterdecke (2.1) eine Gitterwand (2.2) bis zur Unterseite des Bauteilträgers (9) parallel zur Seitenwand (1.3) der Vakuumretorte (1) erstreckt.
